# FASCICULE DE BREVET EUROPEEN

(11) **EP 2 482 317 B1**
(45) Date de publication et mention de la délivrance du brevet: **03.12.2014**
(21) Numéro de dépôt: 12151572.0
(22) Date de dépôt: 18.01.2012
(51) Int. Cl.: H01L 27/148

(54) **Capteur d'image multilineaire à integration de charges**
Multilinearer Bildsensor mit Lastenintegration
Multilinear image sensor with load integration

(30) Priorité: 28.01.2011 FR 1150658
(43) Date de publication de la demande: 01.08.2012
(73) Titulaire: E2V Semiconductors, 38120 Saint Egreve (FR)
(72) Inventeur: Mayer, Frédéric, 38500 VOIRON (FR)
(74) Mandataire: Guérin, Michel

(56) Documents cités:
- US-A1- 2005 046 722
- US-A1- 2008 217 661
- US-B1- 6 465 820

## Description

L'invention concerne les capteurs d'image linéaire à défilement et intégration de signal (ou capteurs TDI, de l'anglais : "Time Delay Integration Linear Sensors"), dans lesquels une image d'une ligne de points d'une scène observée est reconstituée par addition d'images successives prises par plusieurs lignes photosensibles observant successivement une même ligne de la scène au fur et à mesure que la scène défile devant le capteur.

Ces capteurs sont utilisés par exemple dans des scanners. Ils comprennent une barrette de plusieurs lignes parallèles de pixels photosensibles ; le séquencement des circuits de commande des différentes lignes (contrôle de temps d'exposition puis de lecture des charges photogénérées) est synchronisé par rapport au défilement relatif de la scène et du capteur, de manière que toutes les lignes du capteur voient successivement une même ligne de la scène observée. Les signaux générés par chaque ligne sont ensuite additionnés point à point pour chaque point de la ligne observée.

A temps d'exposition constant, la sensibilité du capteur est améliorée dans le rapport du nombre N de lignes, ou bien, à sensibilité constante, le temps d'exposition peut être divisé par N. Ce nombre N peut être par exemple de 16 ou 32 pour des applications de contrôle industriel ou des applications d'observation terrestre à partir de l'espace, ou même de 60 à 100 lignes pour des applications médicales (dentaire, mamographie, ...).

Le rapport signal/bruit est amélioré dans le rapport de la racine carrée du nombre N de lignes du capteur.

De plus, les non-uniformités de sensibilité des pixels d'une même barrette, et les non-uniformités de courant d'obscurité des pixels, sont diminuées par suite du moyennage qui résulte de l'addition des signaux des différentes lignes.

Dans les capteurs d'image à transfert de charges (capteurs CCD), l'addition des signaux point à point se fait simplement en vidant dans une ligne de pixels les charges générées et accumulées dans la ligne de pixels précédente, en synchronisme avec le déplacement relatif de la scène et du capteur. La dernière ligne de pixels, ayant accumulé N fois les charges engendrées par la ligne d'image observée, peut être lue.

La mise en oeuvre des capteurs d'image CCD a l'inconvénient d'utiliser des tensions d'alimentation élevées et consomme une énergie importante ; cette technologie est basée sur l'utilisation de grilles de silicium polycristallin adjacentes et en recouvrement mutuel ; la densité d'intégration n'est pas très élevée.

La technologie des capteurs d'image a ensuite évolué vers des capteurs à pixels actifs à transistors, qu'on appellera ci-après capteurs CMOS pour simplifier car ils sont en général réalisés en technologie CMOS (complementary-metal-oxyde-semiconducteur) ; dans ces capteurs CMOS il n'y a plus de transfert de charges de ligne en ligne vers un circuit de lecture ou un registre mais il y a des pixels actifs à transistors qui recueillent des charges électriques photogénérées et les convertissent directement en une tension ou un courant. Les différentes lignes du capteur fournissent donc successivement des tensions ou courants représentant l'éclairement reçu par la ligne. Ces structures ne permettent pas de réaliser des sommations sans bruit de ces courants ou tensions ; il est donc difficile de réaliser un capteur à défilement et à intégration de charges. La technologie de fabrication est cependant simple, elle consomme peu, et elle fonctionne sous basse tension.

Des tentatives ont cependant été faites pour réaliser des capteurs CMOS à défilement et intégration de charges.

On a essayé en particulier d'utiliser des capacités commutées dans lesquelles on intègre des courants successifs reçus, accumulant ainsi sur une même capacité des charges reçues de plusieurs pixels en colonne (US6906749, WO0126382).

On a également proposé de convertir en valeurs numériques les signaux issus d'une ligne de pixels, de sommer la valeur numérique correspondant au pixel de rang j de la ligne dans un registre accumulateur de rang j qui accumule les valeurs numériques correspondant aux pixels de même rang j de N lignes successives (brevet FR2906080).

Dans le brevet FR2906081, on a proposé d'appliquer à la photodiode d'un pixel d'une ligne la tension de sortie d'un pixel d'une ligne précédente, pour y recopier les charges du pixel précédent, avant d'isoler la photodiode et d'intégrer de nouvelles charges dues à la lumière, de sorte qu'à la fin d'un temps d'intégration la photodiode comprend la somme des charges correspondant à la ligne précédente et les nouvelles charges intégrées. Ce fonctionnement induit cependant un bruit de transfert qui détériore le rapport signal/bruit.

Document US 6465820 décrit un capteur d'image linéaire à défilement et intégration de signal.

Des solutions utilisant une accumulation de charges à l'intérieur du pixel ont été proposées, par exemple dans la publication de brevet US2008/0217661. Elles utilisent une technologie plus complexe que celle qui est strictement nécessaire pour réaliser des capteurs d'image en technologie CMOS, ou bien elles présentent des pertes lors des transferts de charges.

Enfin, dans une demande antérieure non publiée du déposant, on a proposé de constituer des pixels avec une alternance de grilles larges et de photodiodes étroites séparées de la grille par une région p++ au potentiel du substrat et formant une barrière de potentiel empêchant les charges de passer sauf sous des doigts de grille très étroits adjacents à la photodiode. L'étroitesse des doigts de grille crée, par influence des régions p++ qui les touchent, une barrière de potentiel uniquement lorsque la grille est au potentiel bas. Lorsque la grille est au potentiel haut cette barrière s'abaisse suffisamment. La directionalité du transfert est ainsi assurée mais au prix d'une structure plus complexe et au prix de goulots d'étranglements pour le passage des charges.

Les tentatives pour réaliser un capteur linéaire à défilement et intégration de charges utilisant une technologie plus simple que la technologie CCD habituelle n'ont donc pas donné complète satisfaction et un but de l'invention est de proposer une autre solution à ces problèmes.

L'invention a donc pour but de proposer une solution plus avantageuse pour réaliser des capteurs fonctionnant selon le principe des structures à transfert de charges mais utilisant une technologie compatible avec des circuits de technologie CMOS, et notamment une technologie n'utilisant qu'un seul niveau de grille en silicium polycristallin et non un double niveau de grilles en recouvrement mutuel comme c'est le cas dans les technologies CCD classiques.

Selon l'invention, on propose un capteur d'image à transfert de charges fonctionnant en défilement et intégration de charges, le capteur comportant N lignes adjacentes de P pixels en vue d'une observation d'une même ligne d'image successivement par plusieurs lignes de pixels avec une sommation des charges électriques générées par un point d'image dans les pixels de même rang des différentes lignes, les pixels étant formés dans une couche semiconductrice d'un premier type de conductivité recouverte de grilles isolées transparentes à la lumière, et des moyens étant prévus pour appliquer aux grilles une alternance de potentiels hauts et bas permettant le stockage puis le transfert directionnel de charges d'une grille à la suivante **caractérisé en ce qu'**un pixel comprend une succession de plusieurs grilles isolées au-dessus de la couche semiconductrice, les grilles d'un pixel étant séparées les unes des autres et séparées des grilles d'un pixel adjacent d'une autre ligne par des intervalles étroits non recouverts d'une grille situés au-dessus d'une région dopée d'un deuxième type de conductivité recouverte par une région superficielle dopée du premier type, les régions superficielles étant maintenues à un même potentiel de référence, la largeur des intervalles étroits entre grilles adjacentes étant telle que le potentiel interne de la région dopée du deuxième type soit modifié dans toute la largeur de l'intervalle étroit lorsque une grille adjacente à cet intervalle subit l'alternance de potentiels hauts et bas.

Il en résulte en particulier que lorsque deux grilles encadrant un intervalle étroit sont toutes les deux à un même potentiel plus haut ou plus bas que le potentiel de référence, le potentiel interne de la région du deuxième type dans l'intervalle étroit est influencé par le potentiel des grilles et tend à suivre ce potentiel vers le haut ou vers le bas respectivement malgré la présence de la région superficielle portée au potentiel de référence.

Le potentiel de référence est de préférence le potentiel commun de la couche semiconductrice du premier type. Les régions superficielles du premier type de conductivité sont de préférence toutes adjacentes à des diffusions profondes de même type qui rejoignent la couche semiconductrice. Ainsi, les régions superficielles du premier type, situées dans les intervalles étroits entre les grilles, peuvent être toutes mises directement par ce moyen au potentiel de référence de la couche semiconductrice.

Cette structure nouvelle n'utilise qu'un seul niveau de grille car les intervalles étroits entre grilles ne sont pas recouverts par un deuxième niveau de grille ; elle peut donc être réalisée dans une technologie très simple et compatible avec les technologies CMOS. Elle autorise une grande liberté de choix des niveaux de dopage des régions semiconductrices situées entre les grilles. Comme ces dopages déterminent les niveaux de barrières et puits de potentiel créés dans la couche semiconductrice lors de l'application de tensions aux grilles, l'invention permet, par un choix des dopages, d'optimiser le transfert directionnel de charges, sans pertes. On reviendra plus loin sur ce point.

Le pixel est de préférence constitué par quatre grilles adjacentes séparées par des intervalles étroits et il est commandé par quatre phases, c'est-à-dire que toutes les grilles de même rang dans les différents pixels reçoivent une même phase prise parmi les quatre phases. Les phases se succèdent de manière à pousser progressivement les charges dans la direction de transfert désirée.

L'invention s'applique aussi à un pixel à trois grilles adjacentes séparées par des intervalles étroits, commandées par trois phases successives.

D'autres caractéristiques et avantages de l'invention apparaîtront à la lecture de la description détaillée qui suit et qui est faite en référence aux dessins annexés dans lesquels :
- la figure 1 représente une vue en coupe, perpendiculairement au sens des lignes, de la structure d'un capteur photosensible multilinéaire selon I'invention ;
- la figure 2 représente le diagramme des potentiels créés dans le semiconducteur avec les puits de potentiel et les barrières de potentiel dans les différentes phases d'intégration et de transfert, tels qu'ils seraient si les grilles étaient séparés par des intervalles larges ;
- la figure 3 représente le diagramme des potentiels créés dans le semiconducteur dans le cas du capteur selon l'invention pendant quatre étapes de transfert représentant un transfert de charges sur un demi-pixel dans le sens des colonnes ;
- la figure 4 représente le détail de la transition de la deuxième vers la troisième étape.

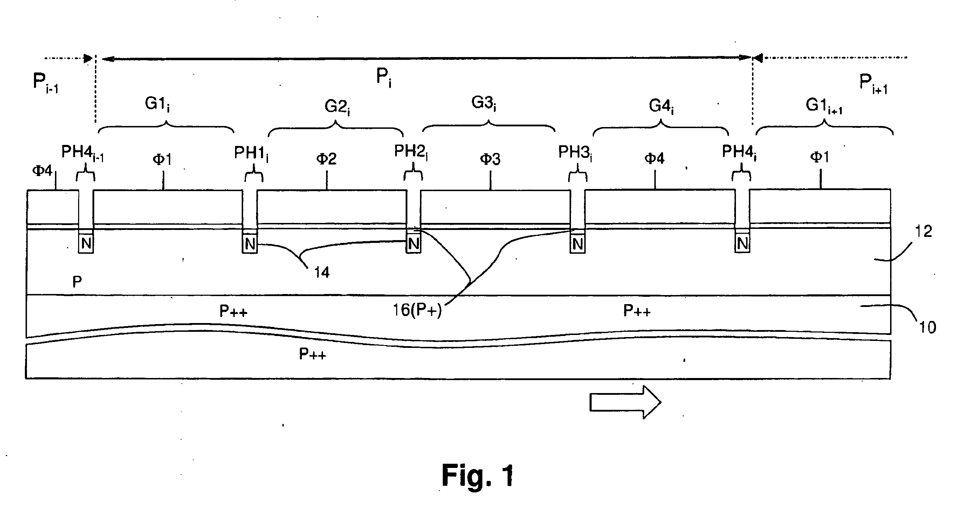

La vue en coupe de la figure 1 représente un pixel Pᵢ adjacent d'un côté à un pixel Pᵢ₋₁ situé en amont, et adjacent de l'autre côté à un pixel Pᵢ₊₁ situé en aval dans la même colonne de pixels. Ces pixels font partie d'une barrette de capteur d'image comportant N lignes adjacentes de P pixels chacune, la barrette étant destinée à fonctionner en mode TDI. Chaque ligne de rang i (i=1 à N) lit successivement une même ligne d'image au cours d'un défilement synchronisé de l'image par rapport à la barrette dans le sens perpendiculaire au sens des lignes ; les charges recueillies par les pixels de même rang j (j=1 à P) dans les différentes lignes correspondent à l'observation d'un même point d'image et sont accumulées pour obtenir un signal plus important (pour un temps d'exposition donné de chaque ligne de pixel) que si une seule ligne voyait l'image ; le rapport signal sur bruit est amélioré par cette lecture multiple d'un même point d'image.

Les colonnes adjacentes à la colonne représentée, non visibles en raison du fait que la vue est une coupe dans le sens de la colonne, sont séparées les unes des autres par des régions d'isolation qui empêchent le passage de charges électriques d'un pixel d'une colonne à un pixel d'une autre colonne. Ces régions d'isolation peuvent être des régions semiconductrices fortement dopées portées à un potentiel de référence créant une barrière de potentiel naturelle entre ces pixels.

Les pixels sont formés dans un substrat semiconducteur 10 dont la partie supérieure est une couche semiconductrice épitaxiale peu dopée 12. Dans cet exemple, le substrat est de type p++ fortement dopé, et la couche épitaxiale est de type p (premier type de conductivité). Si la couche épitaxiale était de type n, il faudrait inverser tous les types de conductivité qui vont maintenant être définis, ainsi que les signes des potentiels appliqués aux photodiodes et aux grilles. Le substrat 10 est en principe de même type de conductivité que la couche épitaxiale 12, mais il pourrait également être de type opposé.

Un pixel Pᵢ comporte, dans le sens de la colonne, une série de plusieurs grilles, dans cet exemple quatre grilles adjacentes G1ᵢ à G4ⱼ, isolées de la couche épitaxiale et séparées les unes des autres par des intervalles étroits non recouverts par une grille. Les intervalles ont de préférence tous la même largeur. La dernière grille G4ᵢ du pixel de rang i est séparée de la première grille G1ᵢ₊₁ du pixel suivant Pᵢ₊₁ par un intervalle étroit qui est de préférence identique aux autres.

Les intervalles étroits ont une largeur qui est à la limite ou presque à la limite de ce que permet la technologie de définition des grilles en production industrielle, lorsque les grilles sont faites à partir d'un seul niveau de couche déposée. La couche déposée pour former les grilles est de préférence en silicium polycristallin. Cette couche repose sur une couche mince d'isolation, de préférence en oxyde de silicium. Un ordre de grandeur typique de la largeur de l'espace étroit est de 0,25 micromètre pour une technologie dite à 0,18 micromètre qui permettrait à la limite de définir des lignes de largeur 0,18 micromètre.

Dans les intervalles étroits, on forme des régions 14 de type n (deuxième type de conductivité, le premier type étant celui de la couche épitaxiale 12). Et au-dessus de chacune des régions 14 de type n ainsi formées entre deux grilles adjacentes, on forme une région superficielle respective 16 du premier type de conductivité (p+, plus dopée que la couche épitaxiale), moins profonde que les régions 14.

Les grilles isolées des pixels sont donc séparées les unes des autres par des régions étroites 14 de type n recouvertes d'une région diffusée superficielle 16 de type p. Les régions de type n 14 sont flottantes, c'est-à-dire qu'elles ne sont pas reliées à un conducteur électrique qui leur appliquerait un potentiel imposé. Les régions 16 de type p sont toutes portées à un même potentiel de référence, et ce potentiel est de préférence celui du substrat 10 qui est en général aussi celui de la couche épitaxiale 12 lorsque celle-ci est de même type que le substrat. On considérera que ce potentiel est un potentiel de référence zéro. Pour porter les régions p au potentiel zéro, on prévoit en pratique que ces régions 16 sont adjacentes à des diffusions fortement dopées de type p qui rejoignent la couche épitaxiale et qui s'alignent sur son potentiel zéro. Ces diffusions, non visibles sur la figure 1, peuvent être les diffusions qui servent à isoler les colonnes de pixels les unes des autres.

Le profil du potentiel en profondeur dans une région 14 dépend d'abord du dopage et de la profondeur de la région 14, ainsi que du dopage de la couche épitaxiale. Si de plus des charges sont stockées dans ces régions, le potentiel dépend de la quantité de charges stockées.

Si les régions 14 étaient larges, c'est-à-dire si leur partie centrale ne subissait pas l'influence des potentiels appliqués aux grilles voisines, le profil de potentiel dans les régions 14 en fonction de la profondeur présenterait naturellement un minimum à une certaine profondeur (au voisinage de la jonction entre la région n et la couche épitaxiale p). Ce minimum a une valeur qu'on appellera potentiel de construction interne V_{bi} (en anglais : *"built-in potential"*) ; cette valeur V_{bi} dépend des valeurs de dopages et de la profondeur des zones dopées. Typiquement, à titre d'exemple, le potentiel de construction d'une photodiode constituée par une région n recouverte d'une région superficielle p maintenue au potentiel de référence zéro peut être d'environ 1,5 volts avec des dopages classiquement utilisés pour des photodiodes. Les régions n 14 recouvertes d'une diffusion superficielle p 16 sont construites comme des photodiodes, et c'est pourquoi on peut faire référence ici à un potentiel de construction interne comme pour des photodiodes.

Cependant, dans le capteur selon l'invention, les intervalles entre grilles sont si étroits que le potentiel dans la région n est fortement influencé par la présence des grilles adjacentes ; on s'écarte donc du fonctionnement d'une photodiode classique dans laquelle le potentiel dans la région n supposée dépourvue de charges resterait fixé en raison du fait que la région superficielle est maintenue au potentiel de référence ; dans le capteur selon l'invention, l'influence des grilles adjacentes s'étend sous toute la largeur des intervalles en raison de leur étroitesse.

L'éclairement des pixels par des photons se fait à travers les grilles. Celles-ci sont transparentes à la lumière dans la gamme des longueurs d'onde visibles (un peu moins transparentes dans le bleu mais très transparentes dans le rouge). Le pixel est donc de type photomos. Dans une moindre mesure (en raison du fait que les espaces entre grilles ont une largeur beaucoup plus faible que les grilles) il y a aussi un éclairement direct des régions n 14 même si cet éclairement contribue de manière faible à la production totale de charges. Les régions n 14 se comportent donc un peu comme des photodiodes de type "pinned" (d'après le mot anglais signifiant "épinglé", qui rappelle que le potentiel de surface de ces régions est fixé). On désigne par PH1ᵢ, PH2ᵢ, PH3ᵢ, PH4ᵢ, les intervalles étroits entre grilles adjacentes du pixel de rang i ; sur la figure 1, on comprendra que PH4ᵢ₋₁ désigne l'intervalle entre la dernière grille du pixel Pᵢ₋₁ et la première grille du pixel Pᵢ.

Cet éclairement de la couche épitaxiale 12 sous les grilles et entre les grilles engendre des charges électriques, et ces charges s'accumulent dans les puits de potentiel formés sous les grilles pendant les périodes d'intégration. Dans ce qui suit on considère que les charges électriques qu'on recueille ainsi sont des électrons. Pour créer des puits de potentiel sous des grilles on appliquera à ces grilles un potentiel positif par rapport au potentiel de la couche épitaxiale ; pour créer des barrières de potentiel sous une grille on appliquera à la grille un potentiel nul par rapport au potentiel de référence de la couche épitaxiale.

Pour mieux faire comprendre la manière dont fonctionne le capteur selon l'invention, on va d'abord montrer quels seraient les diagrammes de potentiels dans la couche semiconductrice 12 au cours des différentes phases d'intégration et de transfert si la largeur des régions 14 était plus importante, c'est-à-dire telle que le potentiel de grille n'influence pas le potentiel des régions 14 sur toute la largeur de celles-ci.

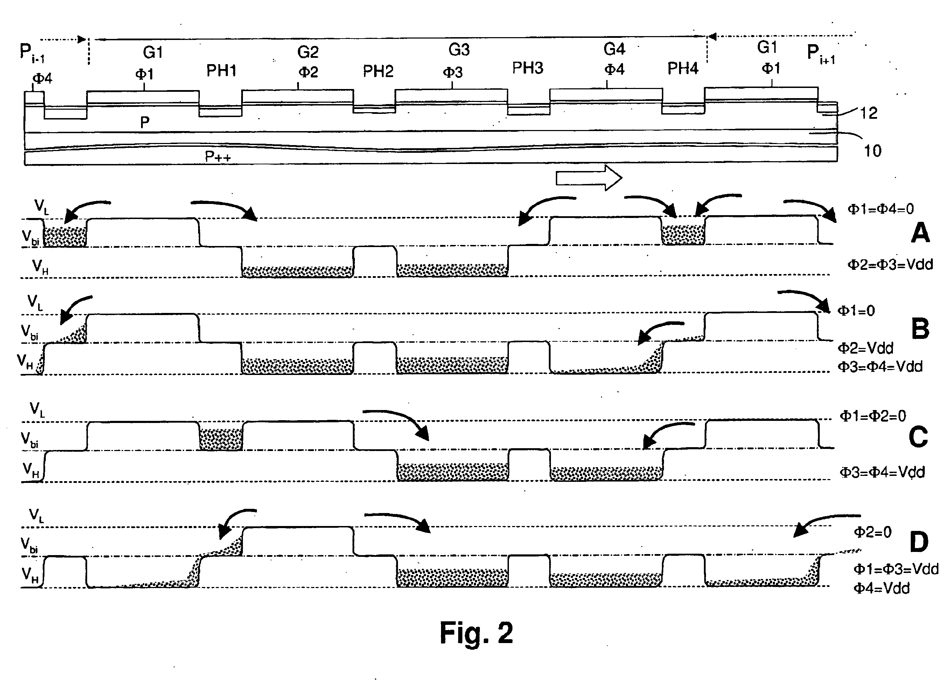

La figure 2 représente cette situation et on suppose que le pixel est un pixel à quatre grilles fonctionnant avec quatre phases de commande Φ 1, Φ2, Φ3, Φ4 appliquées respectivement aux grilles G1, G2, G3, G4 de toutes les lignes. Les phases portent les grilles alternativement à des potentiels 0 et Vdd, qui établissent sous les grilles des potentiels alternativement V_{L} et V_{H} (en l'absence de charges accumulées sous les grilles). Conformément à l'habitude de représentation lorsque les charges accumulées sont des électrons, les potentiels sont croissants vers le bas du diagramme.

On suppose qu'on a choisi les dopages n et p tels que le potentiel de construction interne V_{bi} des régions 14 soit situé à peu près au milieu de l'intervalle entre V_{L} et V_{H}.

Pendant une première étape (ligne A du diagramme ; Φ1, Φ4 à 0, Φ2, Φ3 à Vdd), les grilles G1 et G4 sont portées à un potentiel bas et le grilles G2 et G3 à un potentiel haut. Un puits de potentiel se crée sous les grilles G2 et G3. Des barrières de potentiel se créent sous les grilles G1 et G4. En outre, une barrière de potentiel subsiste dans la région PH2 séparant G2 et G3, et un puits de potentiel (parasite) se crée dans la région 14 située entre une grille G1 et une grille G4 qui la précède. Les charges photogénérées sous les grilles G2 et G3 et sous les régions PH1, PH2 et PH3 s'accumulent dans les puits sous les grilles G2 et G3. Les charges générées sous les grilles G1 et G4 se partagent vers l'amont (vers la gauche) et vers l'aval (vers la droite) et viennent s'ajouter aux charges générées directement sous les grilles G2 et G3 du pixel considéré ou des pixels amont et aval. Mais on voit bien que des charges ont pu se piéger dans le puits de potentiel qui existe sous la région PH4 située en amont de la grille G1, et dans le puits de potentiel qui existe sous la région PH4 en aval de la grille G4. Ces puits sont en effet créés parce que les régions superficielles 16 au potentiel zéro imposent un potentiel égal à V_{bi}, plus haut que V_{L} dans les régions PH4.

Dans la deuxième étape (ligne B du diagramme ; Φ1 à 0, Φ2, Φ3 à Vdd, seule la quatrième phase Φ4 change d'état et passe à Vdd). Par conséquent, seule la grille G4 change pour passer au niveau haut. Des puits de potentiel existent maintenant sous G2, G3, G4, et des barrières de potentiel subsistent dans les régions PH2 et PH3. Les charges photogénérées sous les grilles G2 et G3 et sous les régions PH1 à PH4 s'accumulent sous les grilles G2, G3 et G4. Les charges qui étaient piégées sous la région PH4 du pixel P se déversent vers la grille G4 située vers l'amont.

Dans la troisième étape, (ligne C du diagramme ; Φ1 à 0, seule la deuxième phase Φ2 passe à 0, Φ3, Φ4 sont à Vdd) ; la grille G2 change pour repasser au niveau bas. Elle repousse les charges qu'elle stockait vers le puits de potentiel sous la grille G3 qui est au niveau bas. Mais une partie de ces charges vient se piéger dans le puits de potentiel de profondeur V_{bi} qui se crée alors dans la région PH1 entre les grilles G1 et G2.

Dans la quatrième étape (ligne D du diagramme ; Φ1 passe à Vdd, Φ2 est à 0, Φ3, Φ4 sont à Vdd), seule la grille G1 change en passant au niveau haut. Dans ce passage, les charges piégées dans la région PH1 se déversent vers l'amont alors qu'on souhaite un transfert directionnel vers l'aval de la totalité des charges précédemment stockées sous les grilles G2 et G3.

Une fraction des charges stockées est donc piégée aux étapes A et C et est renvoyée vers l'amont aux étapes B et D.

Dans une cinquième étape non représentée, c'est la grille G3 qui repasse au niveau bas. Les charges accumulées ont avancé d'un demi-pixel par rapport à la configuration de la ligne A puisqu'elles se situent maintenant sous la grille G4 et sous la grille G1 du pixel suivant en aval. Les étapes non représentées, cinq à huit, se déduisent des étapes un à quatre en faisant maintenant jouer à G3 et G4 (c'est-à-dire à Φ3 et Φ4) les rôles précédemment joués par G1 et G2 (Φ1 et (Φ2) et en faisant en conséquence jouer à G1 et G2 les rôles précédemment joués par G3 et G4 :
- on descend la phase Φ3 à zéro,
- puis on monte la phase Φ2 à Vdd ,
- puis on descend la phase Φ4 à 0,
- et enfin on descend la phase Φ1 à 0 conformément à la configuration de la ligne A.

On a alors fait un cycle complet et les charges ont avancé d'un pixel entier et se retrouvent sous les grilles G2 et G3 du pixel suivant.

Pour un fonctionnement de type TDI, l'avance se fait en synchronisme avec le défilement de l'image devant le capteur de sorte que les charges stockées sous les grilles du pixel aval Pᵢ₊₁ sont la somme des charges accumulées par I'éclairement de ce pixel et des charges accumulées par les pixels de rang précédent au moment où ils voyaient le même point d'image.

On voit donc qu'au cours de chaque cycle d'avance des charges, des charges sont renvoyées vers l'arrière à cause du puits de potentiel de profondeur V_{bi} subsistant sous les régions PH qui séparent deux grilles simultanément au potentiel bas.

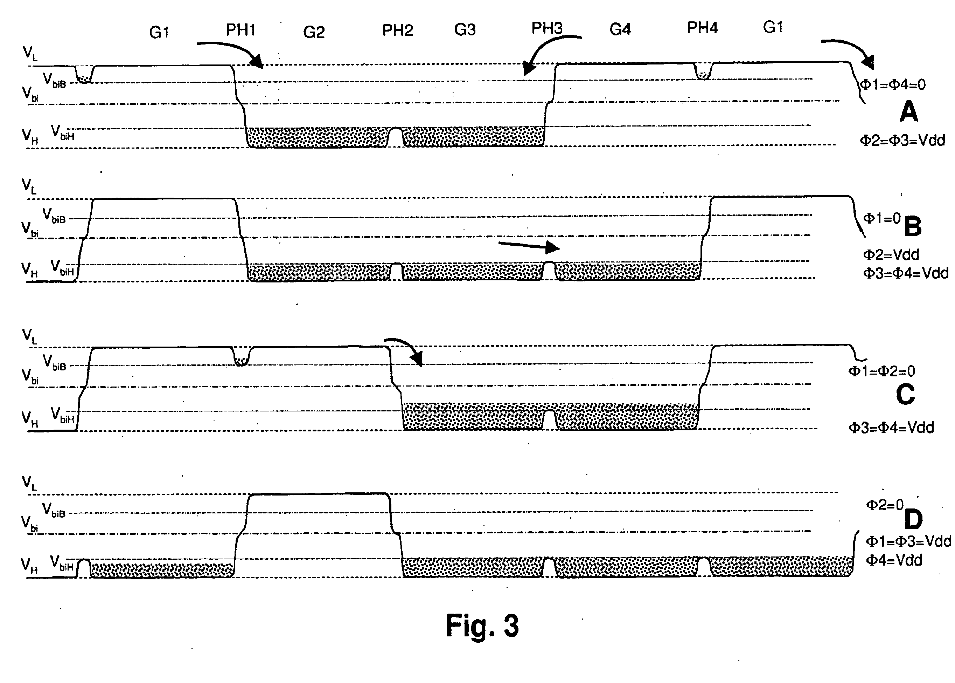

La figure 3 représente maintenant ce qui se passe dans le cas du capteur selon l'invention. On décrira seulement les quatre premières étapes comme à la figure 2, correspondant à l'avance d'un demi-pixel, ces étapes étant suivies par quatre autre étapes identiques pour que les charges avancent d'un pixel entier. On verra qu'un puits de potentiel subsiste encore sous les régions PH qui séparent deux grilles portées simultanément à un potentiel bas. Mais d'une part il est de très faible largeur et très faible profondeur, et d'autre part on montrera que, de manière inattendue, ce puits de potentiel n'est pas gênant car il reste en pratique vide de charges et par conséquent il ne renvoie pas de charges vers l'amont au moment de la deuxième ou la quatrième étape.

Si V_{bi} est le potentiel de construction interne des régions de photodiode PH1 à PH4, résultant directement des niveaux de dopage utilisés, le potentiel réel existant dans ces régions s'écarte fortement du niveau V_{bi} dans toute la largeur de ces régions, en raison de la forte influence des potentiels de grille à 0 volt ou à Vdd. On ne trouvera donc pas dans la figure 3 les paliers de potentiel fixe des régions PH de la figure 2.

Ainsi, si deux grilles adjacentes à une même région 14 sont à 0 volt, le potentiel de la région 14 devient V_{biL} significativement plus bas que V_{bi}. Si les deux grilles sont à Vdd, le potentiel de la région 14 devient V_{biH} significativement plus haut que V_{bi}. Si l'une des grilles est à Vdd, l'autre à 0, le potentiel dans la région 14 varie continûment, sans plateau, du potentiel V_{H} présent sous la première grille au potentiel V_{L} présent sous l'autre.

L'influence du potentiel des grilles sur les régions 14 se fait sentir sur toute la largeur des régions 14 séparant les grilles, en raison de l'étroitesse de ces régions. On a maintenant une configuration dans laquelle on a en quelque sorte deux potentiels de construction interne très différents V_{biL} et V_{biH} dans les régions 14, selon que les deux grilles adjacentes à la région 14 sont toutes les deux au potentiel bas ou toutes les deux au potentiel haut.

Par conséquent, un puits de potentiel peu profond se crée entre les deux grilles au potentiel bas ; et de même une barrière de potentiel peu élevée se crée entre deux grilles au potentiel haut.

Les phases appliquées aux grilles sont exactement les mêmes qu'à la figure 2 et les quatre étapes qui se succèdent pour un transfert d'un demi-pixel de l'amont vers l'aval sont dans l'ordre :
- ligne A du diagramme : Φ1, Φ4 à 0, Φ2, Φ3 à Vdd,
- ligne B du diagramme Φ4 passe à Vdd,
- ligne C du diagramme : Φ2 passe à 0,
- ligne D du diagramme : Φ1 passe à Vdd

Puis on fait jouer à G1 et G2 les rôles précédemment joués par G3 et G4 et réciproquement pour compléter le transfert sur un autre demi-pixel dans les quatre phases qui suivent.

Les charges piégées dans les régions 14 aux étapes A et C sont en faible quantité en raison de l'étroitesse et de la faible profondeur des puits de potentiel de profondeur V_{biL}.

Mais de plus, si on observe précisément ce qui se passe lors du passage de l'étape B à l'étape C (et de l'étape D à l'étape A suivante), on constate qu'il n'y a en pratique aucune charge piégée dans ces puits de potentiel de faible profondeur, et par conséquent aucune charge renvoyée vers l'amont aux étapes qui suivent.

En effet, en raison de l'influence forte des grilles sur le potentiel dans les régions 14, il se passe la chose suivante, par exemple dans le cas du passage de l'étape B à l'étape C : pendant que le potentiel G2 descend pour chasser vers la grille G3 les charges présentes sous la grille G2 , le potentiel de la région PH1, tiré vers le bas du fait de la présence de la grille G1 qui est déjà au potentiel bas, descend en même temps par influence de la grille. Il en résulte que les charges qui sont repoussées par la grille G2 vers la grille G3 à l'étape C ont le temps de se déverser en totalité vers la grille G3 avant qu'un puits de potentiel ne se forme véritablement dans la région PH1. Lorsque ce puits se forme vraiment, à la fin de la descente du potentiel de la grille G2, il ne recueille plus aucune fraction de la charge précédemment accumulée sous la grille G2 car ces charges ont eu le temps de se déverser sous la grille G3.

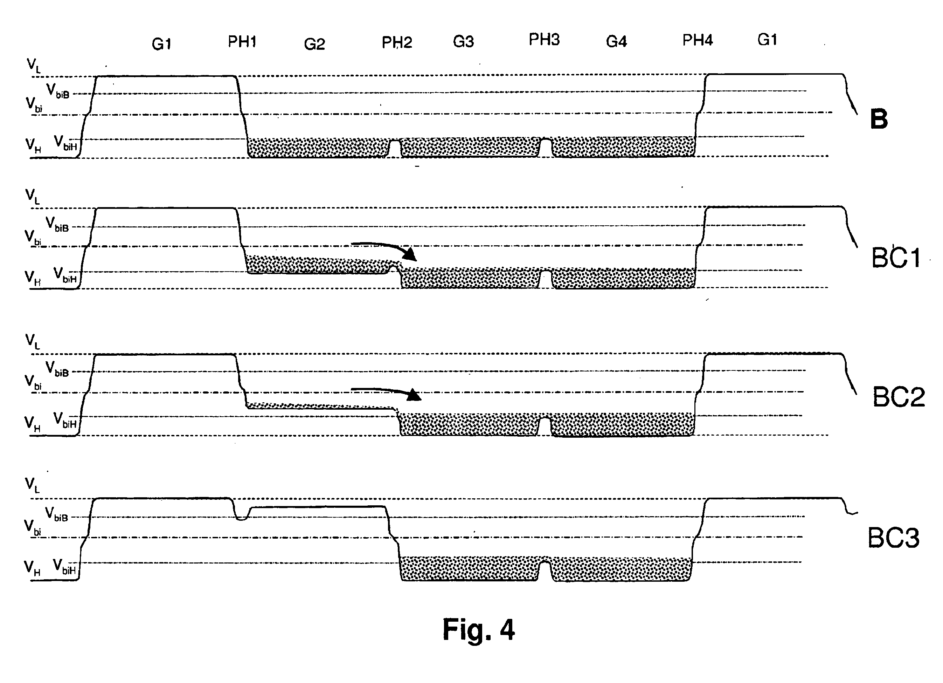

Pour mieux faire comprendre ce déroulement de la transition entre les étapes B et C, on a représenté à la figure 4 en quatre images successives une décomposition de la distribution des potentiels pendant la transition entre les étapes B et C, c'est-à-dire pendant la descente du potentiel de la grille G2 de Vdd à 0.

La ligne B est l'étape de départ, identique à la ligne B de la figure 3.

A la ligne BC1, le potentiel sous la grille G2 commence à descendre, et les charges stockées sous la grille commencent à se déverser sous la grille G3 par-dessus la barrière de potentiel de faible hauteur de la région PH2.

A la ligne BC2, le potentiel continue à descendre ; les charges finissent de se déverser sous G3.

A la ligne BC3, le potentiel est presque arrivé à son niveau bas V_{L} et un puits de potentiel commence à se former sous la région PH1, mais il n'y a plus de charges sous la grille G2 et par conséquent aucune charge ne vient se piéger dans la région PH1.

Par conséquent, dès lors qu'à un moment donné le potentiel sous la grille G2 est au-dessous du potentiel créé sous la région PH2 située en aval de la grille G2, alors que le potentiel sous la grille G2 reste supérieur au potentiel sous la région PH1 située en amont, les charges peuvent se déverser intégralement vers la grille G3. Ceci n'était pas possible dans la structure représentée à la figure 2 (intervalles larges entre grilles) car le potentiel sous la grille G2 ne pouvait pas être à la fois inférieur au potentiel dans la région PH2 et supérieur au potentiel dans la région PH1 puisque ces potentiels étaient identiques.

Des simulations des potentiels sous la grille G2 et dans les régions PH1 (en amont) et PH2 (en aval) pendant la transition de l'étape B à l'étape C montrent que c'est bien ce qui se passe lorsqu'on observe la phase transitoire de descente du potentiel de la grille G2, dès lors que les grilles G2 influencent suffisamment le potentiel dans les intervalles entre grilles pour écarter l'un de l'autre, dans tout l'intervalle entre grilles, le potentiel V_{biL} et le potentiel V_{biH}. On choisira un dopage de région N 14 qui ne soit ni trop faible (il pourrait subsister une barrière de potentiel du côté aval), ni trop fort (un puits de potentiel se creuserait trop vite en amont).

Le dispositif qui a été décrit comporte quatre grilles pour chaque pixel ; les grilles sont commandées chacune par une phase respective parmi quatre phases ; les charges se stockent sous deux grilles adjacentes et il faut huit étapes pour transférer les charges d'un pixel au pixel suivant.

L'invention peut être utilisée également pour un pixel à trois grilles adjacentes commandées par trois phases ; les charges sont stockées sous une grille, et il faut six étapes pour transférer les charges d'un pixel au pixel suivant. Les étapes successives sont :
- Φ2 à Vdd, Φ1 et Φ3 à 0, stockage des charges sous la deuxième grille ;
- Φ3 passe à Vdd, les charges se répartissent sous G2 et G3 ;
- Φ2 passe à zéro, les charges se concentrent sous G3 ; elles ont avancé de la grille G2 vers la grille G3 ;
- Φ1 passe à Vdd, les charges se répartissent entre G3 et la grille G1 du pixel suivant ;
- Φ3 passe à zéro ; les charges se concentrent sous la grille G1 du pixel suivant.

Et ainsi de suite, par permutation circulaire des phases, les charges avancent d'une grille en deux étapes et d'un pixel entier en six étapes.

Enfin, après transfert des charges le long d'une colonne de pixels, on déverse les charges du dernier pixel vers un circuit de lecture de charges. Le circuit de lecture comprend de préférence une diffusion flottante de type N, analogue aux régions N 14 mais non recouverte d'une région superficielle P+, un transistor de lecture, un transistor de réinitialisation constitué par un drain N+ porté à un potentiel de référence positif et une grille de transfert isolée séparant la diffusion flottante du drain. La diffusion flottante est électriquement reliée à la grille du transistor de lecture.

Après la dernière étape d'intégration de charges dans la ligne de rang N, les charges contenues dans la deuxième photodiode du pixel P_{N} sont déversées dans la diffusion flottante du circuit de lecture, à travers une grille finale qui peut être commandée par le potentiel Φ1 comme s'il y avait un N+1^{ème} pixel après le pixel P_{N}. Ce déversement est effectué après une commande de réinitialisation sur la grille de transfert, rendant conducteur le transistor de réinitialisation. Le transistor de lecture est monté en suiveur de tension pour reporter sur sa source le potentiel de sa grille qui représente la quantité de charges déversées dans la diffusion flottante après la réinitialisation.

## Revendications

1. Capteur d'image à transfert de charges fonctionnant en défilement et intégration de charges, le capteur comportant N lignes adjacentes de P pixels en vue d'une observation d'une même ligne d'image successivement par plusieurs lignes de pixels avec une sommation des charges électriques générées par un point d'image dans les pixels de même rang des différentes lignes, les pixels étant formés dans une couche semiconductrice (12) d'un premier type de conductivité recouverte de grilles (G) isolées transparentes à la lumière, et des moyens (Φ) étant prévus pour appliquer aux grilles une alternance de potentiels permettant le stockage puis le transfert directionnel de charges d'une grille à la suivante, un pixel comprenant une succession de plusieurs grilles isolées au-dessus de la couche semiconductrice, les grilles d'un pixel étant séparées les unes des autres et séparées des grilles d'un pixel adjacent d'une autre ligne par des intervalles étroits (PH) non recouverts d'une grille et situés au-dessus d'une région (14) dopée d'un deuxième type de conductivité recouverte par une région superficielle (16) dopée du premier type, les régions superficielles étant maintenues à un même potentiel de référence, **caractérisé en ce que** la largeur des intervalles étroits entre grilles adjacentes est telle que le potentiel interne de la région dopée du deuxième type soit modifié dans toute la largeur de l'intervalle étroit lorsque une grille adjacente à cet intervalle subit l'alternance de potentiels hauts et bas.

2. Capteur d'image selon la revendication 1, **caractérisé en ce que** le potentiel de référence est un potentiel commun de la couche semiconductrice du premier type.

3. Capteur d'image selon la revendication 2, **caractérisé en ce que** les régions superficielles du premier type de conductivité sont toutes adjacentes à des diffusions profondes de même type qui rejoignent la couche semiconductrice

4. Capteur d'image selon l'une des revendications 1 à 3, **caractérisé en ce que** le pixel comprend quatre grilles adjacentes séparées par des intervalles étroits et **en ce qu'**il est commandé par quatre phases, c'est-à-dire que toutes les grilles de même rang dans les différents pixels reçoivent une même phase prise parmi les quatre phases.

5. Capteur d'image selon l'une des revendications 1 à 3, **caractérisé en ce que** le pixel comprend trois grilles adjacentes séparées par des intervalles étroits et **en ce qu'**il est commandé par trois phases, c'est-à-dire que toutes les grilles de même rang dans les différents pixels reçoivent une même phase prise parmi les trois phases.

## Patentansprüche

1. Bildsensor mit Lastenübertragung, der mit Bilddurchlauf und Lastenintegration arbeitet, wobei der Sensor N einander benachbarte Zeilen mit P Pixeln umfasst, für eine Beobachtung einer gleichen Bildzeile aufeinander folgend durch mehrere Pixelzeilen, mit einer Summierung der elektrischen Ladungen, die von einem Bildpunkt in den Pixeln mit gleichem Rang in verschiedenen Zeilen erzeugt werden, wobei die Pixel in einer Halbleiterschicht (12) einer ersten Art von Leitfähigkeit gebildet werden, beschichtet mit isolierten Gittern (G), die für das Licht durchsichtig sind, und wobei Mittel (Ø) dazu vorgesehen sind, um auf die Gitter einen Potenzialpolwechsel anzulegen, der die Speicherung und dann die gerichtete Übertragung von Lasten von einem Gitter zum folgenden ermöglicht, wobei ein Pixel eine Aufeinanderfolge von mehreren isolierten Gittern über der Halbleiterschicht umfasst, wobei die Gitter eines Pixels voneinander getrennt und von den Gittern eines benachbarten Pixels einer anderen Zeile um enge Abstände (PH) getrennt sind, die nicht mit einem Gitter beschichtet sind und sich über einem Bereich (14) befinden, der mit einer zweiten Art von Leitfähigkeit dotiert ist, beschichtet mit einem dotierten Oberflächenbereich (16) der ersten Art, wobei die Oberflächenbereiche auf einem gleichen Referenzpotenzial gehalten werden, **dadurch gekennzeichnet, dass** die Breite der engen Abstände zwischen benachbarten Gittern derart ist, dass das innere Potenzial des dotierten Bereichs der zweiten Art auf der gesamten Breite des engen Abstands modifiziert wird, wenn ein benachbartes Gitter zu diesem Abstand den Polwechsel der hohen und der niedrigen Potenziale durchläuft.

2. Bildsensor nach Anspruch 1, **dadurch gekennzeichnet, dass** das Referenzpotenzial ein gemeinsames Potenzial der Halbleiterschicht der ersten Art ist.

3. Bildsensor nach Anspruch 2, **dadurch gekennzeichnet, dass** die Oberflächenregionen der ersten Art von Leitfähigkeit alle tiefen Diffusionen der gleichen Art benachbart sind, die auf die Halbleiterschicht treffen.

4. Bildsensor nach einem der Ansprüche 1 bis 3, **dadurch gekennzeichnet, dass** das Pixel vier einander benachbarte Gitter umfasst, die durch enge Abstände getrennt sind, und dadurch, dass er durch vier Phasen gesteuert wird, d.h. alle Gitter des gleichen Rangs in den verschiedenen Pixeln erhalten eine gleiche Phase, entnommen aus den vier Phasen.

5. Bildsensor nach einem der Ansprüche 1 bis 3, **dadurch gekennzeichnet, dass** das Pixel drei einander benachbarte Gitter umfasst, die durch enge Abstände getrennt sind, und dadurch, dass er durch drei Phasen gesteuert wird, d.h. alle Gitter des gleichen Rangs in den verschiedenen Pixeln erhalten eine gleiche Phase, entnommen aus den drei Phasen.

## Claims

1. Charge-transfer image sensor operating in time-delay and charge integration, the sensor comprising N adjacent lines of P pixels for the purpose of an observation of one and same image line successively by several lines of pixels with accumulation of the electrical charges generated by an image point in the pixels of one and the same row of the various lines, the pixels being formed in a semiconducting layer (12)of a first type of conductivity covered by insulated gates (G)transparent to the light, and means (Φ) being provided for applying to the gates an alternation of potentials allowing the storage and then the directional transfer of charges from one gate to the next, a pixel comprising a succession of several insulated gates above the semiconducting layer, the gates of one pixel being separated from one another and separated from the gates of an adjacent pixel of another line by narrow uncovered gaps (PH) located above a doped region (14) of a second type of conductivity covered by a doped superficial region (16) of the first type, the superficial regions being kept at one and the same reference potential, **characterized in that** the width of the narrow gaps between adjacent gates is such that the internal potential of the doped region of the second type is modified in the whole width of the narrow gap when a gate adjacent to this gap receives the alternation of high and low potentials.

2. Image sensor according to Claim 1, **characterized in that** the reference potential is a common potential of the semiconducting layer of the first type.

3. Image sensor according to Claim 2, **characterized in that** the superficial regions of the first type of conductivity are all adjacent to deep diffusions of the same type that join the semiconducting layer.

4. Image sensor according to one of Claims 1 to 3, **characterized in that** the pixel comprises four adjacent gates separated by narrow gaps and **in that** it is controlled by four phases, that is to say that all the gates of the same row in the various pixels receive one and the same phase taken from the four phases.

5. Image sensor according to one of Claims 1 to 3, **characterized in that** the pixel comprises three adjacent gates separated by narrow gaps and **in that** it is controlled by three phases, that is to say that all the gates of one and the same row in the various pixels receive one and the same phase taken from the three phases.
